# FASCICULE DE BREVET EUROPEEN

(11) **EP 0 495 698 B1**
(45) Date de publication et mention de la délivrance du brevet: **05.10.1994**
(21) Numéro de dépôt: 92400064.9
(22) Date de dépôt: 10.01.1992
(51) Int. Cl.: G01R 31/308, G01R 31/26

(54) **Procédé et dispositif de test de diodes à jonction apparente assemblées en parallèle**
Verfahren und Gerät zur Prüfung paralellgeschalteter Dioden mit sichtbaren Übergängen
Procedure and apparatus for testing diodes connected in parallel with apparent junction

(30) Priorité: 15.01.1991 FR 9100366
(43) Date de publication de la demande: 22.07.1992
(73) Titulaire: THOMSON-CSF, 75008 Paris (FR)
(72) Inventeur: Prigent, Jean-Luc, F-92045 Paris la Défense (FR)
(74) Mandataire: Beylot, Jacques

(56) Documents cités:
- DE-A- 3 617 588
- FR-A- 2 469 808
- IBM TECHNICAL DISCLOSURE BULLETIN. vol. 25, no. 10, Mars 1983, NEW YORK USpages 5052 - 5054; C. C. CHI ET AL.: 'OPTICAL PROBING AND TESTING...'
- JAPANESE JOURNAL OF APPLIED PHYSICS. vol. 22, no. 2-1, Février 1983, TOKYO JPpages 276 - 280; MOROHASHI ET AL.: 'MEASUREMENT OF MINORITY-CARRIER DIFFUSION..
- IEEE TRANSACTIONS ON ELECTRON DEVICES. vol. ED-34, no. 4, Avril 1987, NEW YORKUS pages 911 - 919; STENGL: 'HIGH VOLTAGE PLANAR JUNCTIONS INVESTIGATED...'

## Description

### PROCEDE ET DISPOSITIF DE TEST DE DIODES A JONCTION APPARENTE ASSEMBLEES EN PARALLELE

La présente invention concerne la vérification du bon fonctionnement de diodes à jonction apparente disposées en parallèle au sein d'un groupe, plusieurs groupes de diodes pouvant être eux mêmes connectés entre eux en série.

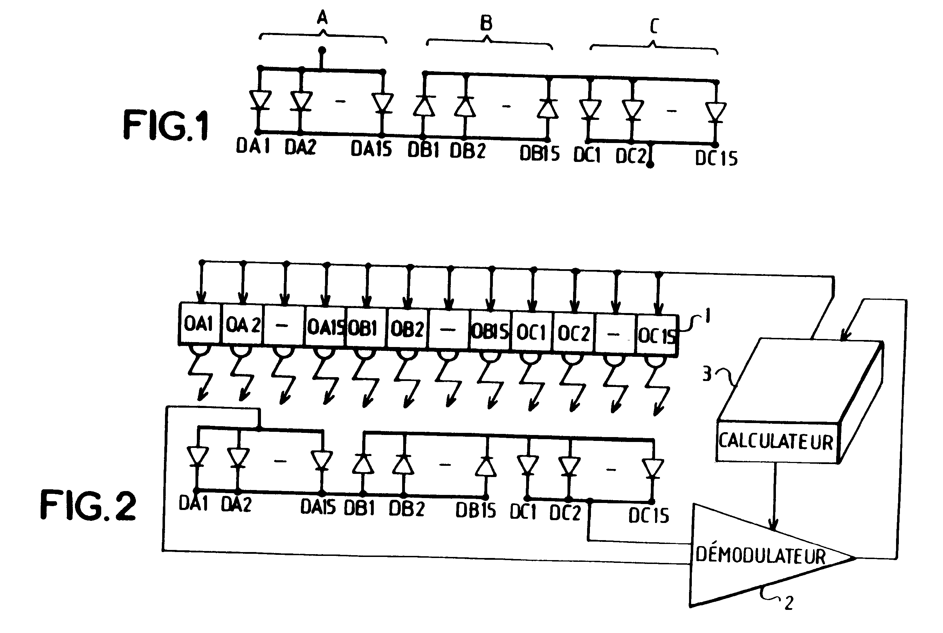

On rencontre des montages série-parallèle de diodes tels que celui représenté à la figure 1, notamment, dans certaines lentilles de dépointage d'antenne hyperfréquence utilisées pour réaliser un balayage électronique de l'espace. Ces lentilles comportent une juxtaposition de canaux déphaseurs renfermant chacun, entre deux plaques métalliques parallèles à la direction de propagation du faisceau, un empilement de barrettes allongées qui sont disposées parallèlement au plan d'onde du faisceau et qui sont constituées chacune d'une carte de circuit imprimé supportant un réseau de fils conducteurs disposés en échelle avec des barreaux parallèles à la direction du champ électrique. Les barreaux sont divisés en deux morceaux réunis par des diodes qui permettent de les rendre à volonté continus ou interrompus du point de vue électrique. Cela modifie leurs impédances et, par conséquent, le déphasage subi par l'onde hyperfréquence incidente. Les diverses combinaisons de déphasage qu'il est possible de faire subir à l'onde hyperfréquence dans sa traversée des canaux déphaseurs permettent de défléchir à volonté le faisceau hyperfréquence dans différentes directions pour assurer un balayage de l'espace.

Pour éviter que la mise en court-circuit d'une diode ne perturbe le fonctionnement de toutes les autres diodes d'une barrette, les fils d'interconnexion disposés selon les montants de l'échelle sont fractionnés. Cela conduit à une répartition des diodes en plusieurs groupes au sein desquels elles sont connectées en parallèle dans le même sens, les groupes étant eux mêmes connectés entre eux en série dans le même sens.

Pour plus de détails sur ces barrettes et leurs assemblages de diodes au sein d'une lentille de dépointage d'antenne hyperfréquence, on peut se reporter au brevet français FR-A- 2.469.808.

Pour tester le bon fonctionnement des diodes d'une barrette, il est possible d'alimenter l'ensemble du montage par un générateur de courant haché et de vérifier la présence du courant dans chaque diode en déplaçant la barrette sous une sonde de mesure de courant. Cependant, aux longueurs d'ondes hyperfréquences envisagées, les faibles longueurs des fils de connexion des diodes qui constituent les barreaux de l'échelle ne permettent pas une distinction aisée entre les courants circulant dans les diodes et ceux circulant dans les fils d'interconnexion constituant les barreaux de l'échelle.

D'autre part, la durée du test est relativement longue en raison du temps nécessaire pour déplacer la barrette et faire venir une à une les diodes sous la sonde de mesure de courant.

La solution qui consiste à utiliser autant de sondes de mesure de courant que de diodes est inacceptable en raison du prix de revient élevé d'une sonde de mesure de courant.

Il est connu du document IBM Technical Disclosure Bulletin, vol. 25, no. 10, Mars 1983 "Optical Probingand Testing" d'utiliser la sensibilité photo-électrique des jonctions semiconductrices. Le procédé de test consiste à effectuer un balayage laser sur les éléments semiconducteurs et en mesurant le courant induit.

La présente invention a pour but de lutter contre ces divers inconvénients et de permettre un test facilement évolutif, rapide, fiable et à faible prix de revient, de diodes en montage parallèle ou série-parallèle.

Elle consiste à utiliser la sensibilité photo-électrique des jonctions semiconductrices des diodes à base de silicium, arséniure de gallium etc..

Elle a pour objet un procédé de test de diodes à jonction apparente assemblées en un montage série-parallèle, lesdites diodes étant réparties en groupes au sein desquels elles sont connectées en parallèle, les groupes de diodes étant eux mêmes connectés entre eux en série. Ce procédé consiste, pour tester une diode déterminée du montage, à éclairer par intermittence la jonction de la diode considérée et à éclairer simultanément en continu les )onctions d'au moins une diode de chacun des groupes autres que celui d'appartenance de la diode considérée avec des pinceaux lumineux dont les longueurs d'onde appartiennent aux plages de sensibilité opto-électrique desdites jonctions, à refermer le montage série-parallèle de diodes aux bornes d'une charge électrique et à constater l'apparition, aux bornes de cette charge, d'un photocourant intermittent traduisant le bon fonctionnement de la diode considérée.

De manière avantageuse, ce procédé de test peut comporter une étape supplémentaire au cours de laquelle on cesse, à tour de rôle, l'éclairement en continu de la ou des diodes de chacun des groupes autres que celui d'appartenance de la diode considérée, pour constater la disparition du photocourant intermittent aux bornes de la charge et en déduire l'absence de court-circuit au sein du groupe auquel appartiennent la ou les diodes dont on vient de cesser l'éclairement de la jonction.

L'invention a également pour objet un dispositif de mise en oeuvre des procédés précités.

D'autres caractéristiques et avantages de l'invention ressortiront de la description ci-après d'un mode de réalisation donné à titre d'exemple. Cette description sera faite en regard du dessin dans lequel :
- une figure 1, représente un exemple de montage série-parallèle de diodes à tester et
- une figure 2, représente un schéma d'un dispositif de mise en oeuvre du procédé de test selon l'invention.

La figure 1 donne un exemple de montage série-parallèle de diodes à tester. Celui-ci se compose d'un ensemble de quarante cinq diodes à jonction apparente, c'est à dire non encapsulées ou encapsulées dans une matière transparente aux ondes lumineuses dans la plage de sensibilité photo-électrique de leur jonction. Ces diodes sont disposées côte à côte sur une bande de circuit imprimé, comme les barreaux d'une échelle avec des fils d'interconnexion disposés de part et d'autre à la manière des montants d'une échelle. Elles sont interconnectées de façon à pouvoir être rendues simultanément conductrices ou bloquées. Du point de vue électrique, elles sont réparties en trois groupes A, B, C de quinze diodes DA1,.. DA15, DB1,.., DB15, DC1,.., DC15 au sein desquels elles sont connectées en parallèle et dans le même sens, les trois groupes A, B, C étant eux mêmes connectés entre eux, en série et dans le même sens. Le montage série-parallèle des diodes tel qu'il est représenté, plutôt qu'un montage purement parallèle permet de circonscrire les effets d'un court-circuit au niveau d'un groupe de diodes.

La figure 2 illustre un dispositif de test. Celui-ci comporte une batterie 1 de diodes électroluminescentes, un démodulateur détecteur de photocourant 2 connecté en entrée aux bornes du montage série-parallèle de diodes à tester et un calculateur 3 commandant individuellement les éclairements des diodes électroluminescentes de la batterie 1 et contrôlant le démodulateur détecteur de photocourant 2.

Les diodes électroluminescentes OA1,.., OA15, OB1,.., OB15, OC1,.., OC15 engendrent une lumière dont la longueur d'onde appartient à la plage de sensibilité photoélectrique des jonctions des diodes DA1,..,DC15 du montage à tester. De même nombre que les diodes du montage à tester, elles sont réparties selon la même disposition que ces dernières. Lorsque le montage série-parallèle des diodes à tester est en place dans le dispositif de test, chaque diode électroluminescente OA1,,., OC15 se retrouve en vis à vis de la diode du montage à tester qui à la même rang dans le groupe considéré A, B ou C et permet d'éclairer uniquement la jonction de cette dernière. Un dispositif de collimation équipe au besoin chaque diode électroluminescente pour limiter la surface de leur faisceau lumineux afin qu'il n'intercepte que la jonction de la diode à tester située en regard. Chaque diode électroluminescente peut également être une diode laser émettant un étroit pinceau lumineux.

Le démodulateur détecteur de photocourant 2 présente une résistance interne d'entrée qui constitue la charge électrique du montage série-parallèle des diodes sous test. Il reçoit du calculateur 3 un signal alternatif carré à la fréquence à laquelle ce dernier commande une illumination intermittente de l'une des diodes du montage sous test de manière à effectuer une démodulation synchrone. Il délivre en réponse au calculateur un signal binaire dont le niveau atteste de la détection ou non dans le montage sous test d'un courant intermittent de même fréquence d'apparition.

Le calculateur 3 pilote la batterie 1 de diodes électroluminescentes et le démodulateur 2 de manière à tester successivement toutes les diodes DA1,.., DC15 du montage selon la procédure suivante :
- allumage intermittent de la diode électroluminescente éclairant la jonction de la diode considérée dans le montage, par exemple allumage de la diode électroluminescente OA2 pour le test de la diode DA2 du montage grâce à un signal d'excitation alternatif carré ;
- allumage simultané, en continu, des diodes électroluminescentes éclairant les jonctions d'au moins une diode de chacun des groupes autres que celui d'appartenance de la diode considérée, ce qui peut correspondre dans l'exemple précédent à l'allumage en continu des diodes électroluminescentes OB2 et OC2, et
- vérification de la présence d'un courant intermittent dans le montage sous test par prise en compte du niveau du signal de sortie du démodulateur 2.

Cette procédure de test de chaque diode du montage peut être complétée par une étape supplémentaire consistant à éteindre, à tour de rôle, les diodes électroluminescentes (OB2 et OC2 dans l'exemple précédent) éclairant des jonctions de diodes de chacun des groupes autres que celui d'appartenance de la diode considérée pour constater, à chaque fois, la disparition du courant intermittent circulant dans le montage sous test.

La diode en cours de test (DA2 dans l'exemple considéré), qui a sa jonction éclairée par intermittence, doit se comporter, si elle est bonne, comme un générateur de courant photo-électrique intermittent. Ce n'est pas le cas des autres diodes du même groupe (A dans l'exemple considéré) qui restent bloquées puisque leurs jonctions ne sont pas éclairées.

Les diodes (DB2 et DC2 dans l'exemple considéré) des autres groupes (B et C dans l'exemple considéré) qui ont leurs jonctions éclairées en continu se comportent en générateurs de courant photoélectrique continu disposés en série et dans le même sens que le générateur de courant photoélectrique intermittent de la diode sous test (DA2 dans l'exemple considéré) et laissent parvenir au démodulateur 2 un courant photoélectrique intermittent attestant du bon fonctionnement de la diode sous test.

Lorsque l'on cesse l'éclairement continu des jonctions des diodes de chacun des groupes (B ou C dans l'exemple considéré) autres que celui d'appartenance de la diode sous test, le courant photoélectrique intermittent doit cesser car il ne peut franchir la tension de seuil des diodes de ces groupes. Si ce n'est pas le cas l'une au moins des diodes du groupe dont on a cessé l'éclairement est un court-circuit.

Une fois terminée la procédure de test d'une diode (DA2 dans l'exemple considéré) on recommence les opérations pour une autre diode et ainsi de suite jusqu'à ce que toutes les autres diodes du montage aient été testées.

Dans le cas où le montage de diodes à tester ne présente qu'un groupe de diodes connectées en parallèle, la procédure se simplifie puisqu'il suffit alors d'éclairer une à une les jonctions des diodes du groupe avec une lumière continue ou intermittente et de détecter selon le cas, la circulation d'un courant photoélectrique continu ou intermittent.

Grâce aux procédures décrites, le test des jonctions de diodes en montage parallèle ou série-parallèle devient très simple, alors qu'il était relativement compliqué avec les méthodes traditionnelles.

## Revendications

1. Procédé de test de diodes à jonction apparente assemblées en un montage série-parallèle, lesdites diodes étant réparties en groupes (A, B, C) au sein desquels elles sont connectées en parallèle, les différents groupes (A, B, C) de diodes étant eux mêmes connectés entre eux en série, caractérisé en ce qu'il consiste, pour tester une diode déterminée (DA2) du montage, à éclairer par intermittence la jonction de la diode considérée (DA2) et à éclater simultanément, en continu, les jonctions d'au moins une diode (DB2, DC2) de chacun (B, C) des groupes autres que celui (A) d'appartenance de la diode considérée (DA2) avec des pinceaux lumineux dont les longueurs d'ondes appartiennent aux plages de sensibilité photoélectrique desdites jonctions, à refermer le montage série-parallèle de diodes aux bornes d'une charge électrique et à constater l'apparition, aux bornes de ladite charge, d'un photocourant intermittent traduisant le bon fonctionnement de la diode considérée (DA2).

2. Procédé selon la revendication 1, caractérisé en ce qu'il consiste en outre, lors du test d'une diode déterminée (DA2) du montage, à cesser, à tour de rôle, l'éclairement continu de la ou des diodes (DB2 ou DC2) de chacun des groupe (B, C) autres que celui (A) d'appartenance de la diode considérée (DA2) pour constater la disparition du photocourant intermittent aux bornes de la charge et en déduire l'absence de court-circuit au sein du groupe (B ou C) auquel appartiennent la ou les diodes (DB2 ou DC2) dont on vient de cesser d'éclairer la jonction.

3. Dispositif de mise en oeuvre du procédé selon la revendication 1, caractérisé en ce qu'il comporte :
- une batterie (1) de diodes électroluminescentes qui engendrent chacune une lumière dont la longueur d'onde appartient à la plage de sensibilité photoélectrique des jonctions des diodes à tester et qui sont susceptibles d'éclairer à volonté lesdites diodes à tester ;
- un détecteur de photocourant (2) connecté en entrée aux bornes du montage de diodes à tester et
- un calculateur (3) commandant les éclairements des diodes électroluminescentes de la batterie (1) et contrôlant le détecteur de photocourant (2).

4. Dispositif selon la revendication 3, caractérisé en ce que les diodes électroluminescentes (OA1,..OC15) de la batterie (1) sont en nombre égal à celui des diodes (DA1,..DA15) du montage à tester et sont réparties selon une même disposition.

## Patentansprüche

1. Verfahren zum Testen von Dioden mit sichtbarem Übergang, die in einer Serien-Parallel-Schaltung zusammengefügt sind, wobei die Dioden in Gruppen (A, B, C) unterteilt sind, in deren Inneren sie parallel miteinander verbunden sind, wobei die verschiedenen Diodengruppen (A, B, C) untereinander in Reihe verbunden sind, dadurch gekennzeichnet, daß es zum Testen einer bestimmten Diode (DA2) der Schaltung darin besteht, den Übergang der betrachteten Diode (DA2) intermittierend zu beleuchten und gleichzeitig die Übergänge von wenigstens einer Diode (DB2, DC2) jeder (B, C) der anderen Gruppen als der Gruppe (A), zu der die betrachtete Diode (DA2) gehört, kontinuierlich mit Lichtstrahlen zu beleuchten, deren Wellenlängen dem Bereich der photoelektrischen Empfindlichkeit der Übergänge angehört, sowie die SerienParallel-Schaltung der Dioden mit den Anschlüssen einer elektrischen Last zu verbinden und an den Anschlüssen der Last das Auftreten eines intermittierenden Photostromes festzustellen, der das korrekte Arbeiten der betrachteten Diode (DA2) angibt.

2. Verfahren nach Anspruch 1, dadurch gekennzeichnet, daß es außerdem darin besteht, beim Test einer bestimmten Diode (DA2) der Schaltung der Reihe nach die Beleuchtung der Diode oder der Dioden (DB2 oder DC2) jeder der anderen Gruppen (B, C) als der Gruppe (A), zu der die betrachtete Diode (DA2) gehört, einzustellen, um das Verschwinden des intermittierenden Photostromes an den Anschlüssen der Last festzustellen und daraus auf das Fehlen eines Kurzschlusses im Inneren der Gruppe (B oder C) zu schließen, zu der die Diode oder die Dioden (DB2 oder DC2) gehören, bei denen die Beleuchtung der Übergänge eingestellt wurde.

3. Vorrichtung zum Ausführen des Verfahrens nach Anspruch 1, dadurch gekennzeichnet, daß sie enthält:
- eine Batterie (1) von Elektrolumineszenzdioden, die jeweils ein Licht erzeugen, dessen Wellenlänge dem Bereich der photoelektrischen Empfindlichkeit der Übergänge der zu testenden Dioden angehört, und die in der Lage sind, die zu testenden Dioden willkürlich zu beleuchten;
- einen Photostrom-Detektor (2), dessen Eingang mit den Anschlüssen der zu testenden Diodenschaltung verbunden ist, und
- einen Rechner (3), der das Aufleuchten der Elektrolumineszenzdioden der Batterie(l) steuert und den Photostrom-Detektor (2) überwacht.

4. Vorrichtung nach Anspruch 3, dadurch gekennzeichnet, daß die Elektrolumineszenzdioden (OA1,...OC15) der Batterie (1) von gleicher Anzahl wie die Dioden (DA1,...DA15) der zu testenden Schaltung und in einer gleichen Anordnung verteilt sind.

## Claims

1. Test method for diodes with exposed junctions assembled into a series-parallel assembly, the said diodes being distributed into groups (A, B, C) within which they are connected in parallel, the various groups (A, B, C) of diodes themselves being connected together in series, characterized in that it consists, in order to test a specific diode (DA2) of the assembly, in intermittently illuminating the junction of the diode in question (DA2) and in simultaneously illuminating, continuously, the junctions of at least one diode (DB2, DC2) of each (B, C) of the groups other than the one (A) to which the diode in question (DA2) belongs with pencil beams of light whose wavelengths belong to the range of photoelectric sensitivity of the said junctions, in connecting the series-parallel assembly of diodes to the terminals of an electrical load and in noting the appearance, at the terminals of the said load, of an intermittent photocurrent denoting correct operation of the diode in question (DA2).

2. Method according to Claim 1, characterized in that it further consists, during testing of a specific diode (DA2) of the assembly, in ceasing, in turn, the continuous illumination of the diode or diodes (DB2 or DC2) of each of the groups (B, C) other than the one (A) to which the diode in question (DA2) belongs in order to note the disappearance of the intermittent photocurrent at the terminals of the load and to deduce therefrom the absence of a short circuit within the group (B or C) to which the diode or diodes (DB2 or DC2) belong whose junction has just ceased to be illuminated.

3. Device for implementing the method according to Claim 1, characterized in that it comprises:
- an array (1) of light-emitting diodes which each generate light whose wavelength belongs to the range of photoelectric sensitivity of the junctions of the diodes to be tested and which are capable of illuminating the said diodes to be tested on demand;
- a photocurrent detector (2) whose input is connected to the terminals of the assembly of diodes to be tested and
- a computer (3) controlling the illumination of the light-emitting diodes of the array (1) and monitoring the photocurrent detector (2).

4. Device according to Claim 3, characterized in that the light-emitting diodes (OA1,..OC15) of the array (1) are equal in number to the diodes (DA1,..DA15) of the assembly to be tested and are distributed in the same arrangement.
